# EUROPEAN PATENT APPLICATION

(11) **EP 2 555 397 A1**
(43) Date of publication of application: **06.02.2013**
(21) Application number: 11765845.0
(22) Date of filing: 01.04.2011
(51) Int. Cl.: H02M 1/08

(54) **POWER CONVERTER DEVICE**

(30) Priority: 01.04.2010 JP 2010084774
(71) Applicant: Hitachi Automotive Systems, Ltd., Hitachinaka-shi Ibaraki 312-8503 (JP)
(72) Inventor: SHIMANO, Hiroki, Hitachinaka-shi Ibaraki 312-8503 (JP); NOTO, Yasuo, Hitachinaka-shi Ibaraki 312-8503 (JP); YAHATA, Koichi, Hitachinaka-shi Ibaraki 312-8503 (JP); FUNABA, Seiji, Hitachinaka-shi Ibaraki 312-8503 (JP); AKAISHI, Yoshio, Hitachinaka-shi Ibaraki 312-8503 (JP)
(74) Representative: MERH-IP Matias Erny Reichl Hoffmann
(86) International application number: PCT/JP2011/058443
(87) International publication number: WO 2011/125945

(57) **Abstract**

The present invention provides a power converter including a power semiconductor device, a driver circuit section that outputs a driving signal for driving the power semiconductor device, a buffer circuit section that includes a PNP transistor and an NPN transistor and that outputs a gate voltage for driving the power semiconductor device, a first delay circuit section that receives the driving signal and that generates a first delay signal on the basis of the received driving signal, a first MOSFET that has a drain electrode connected with the output of the buffer circuit section and that is driven on the basis of the first delay signal. A current flows through the buffer circuit section and the first MOSFET on the basis of the received driving signal, the first delay circuit section outputs the first delay signal after the buffer circuit section exits the transient state and turns on, and the gate voltage is applied to the power semiconductor device from the buffer circuit section to turn the power semiconductor device on by the switching operation of the first MOSFET based on the first delay signal.

## Description

### Technical Field

The present invention relates to an inverter circuit for hybrid electric vehicles (HEVs) or electric vehicles (EVs), a power converter using such an inverter circuit, and a hybrid electric vehicle using such a power converter, and more specifically to an inverter circuit suitable for use in controlling a power semiconductor device, a power converter using such an inverter circuit, and a hybrid electric vehicle or electric vehicle using such a power converter.

### Background Art

IGBTs have been widely used as power semiconductor devices for high voltage inverters mounted on hybrid electric vehicles (HEVs) or electric vehicles (EVs). However, as switching losses generated in IGBTs are relative high, these losses must be reduced when they are used in inverter systems. For example, patent literature 1 describes a technique for reducing noise by increasing the turning-off speed in the first half of the turn-off operation of an IGBT and reducing the turning-off speed in the second half thereof in order to reduce the switching losses.

However, as the carrier frequencies of inverters become higher, not only the turn-off operations of IGBTs but also the turn-on operations thereof are starting to significantly affect the losses generated in inverter systems. As a result, further reductions in the losses generated during the switching operations of IGBTs including those generated during the turn-on operations thereof are required.

### Citation List

### Patent Literature

Patent Literature 1: Japanese Unexamined Patent Application Publication No. 2009-55696

### Summary of Invention

### Technical Problem

An object of the present invention is to further reduce the losses generated during the switching operations including those generated during the turn-on operations.

### Solution to Problem

According to a first aspect of the present invention, there is provided a power converter including a power semiconductor device, a driver circuit section that outputs a driving signal for driving the power semiconductor device, a buffer circuit section that includes a PNP transistor and an NPN transistor and that outputs a gate voltage for driving the power semiconductor device, a first delay circuit section that receives the driving signal and that generates a first delay signal on the basis of the received driving signal, a first MOSFET that has a drain electrode connected with the output of the buffer circuit section and that is driven on the basis of the first delay signal. A current flows through the buffer circuit section and the first MOSFET on the basis of the received driving signal, the first delay circuit section outputs the first delay signal after the buffer circuit section exits the transient state and turns on, and the gate voltage is applied to the power semiconductor device from the buffer circuit section to turn the power semiconductor device on by the switching operation of the first MOSFET based on the first delay signal. According to a second aspect of the present invention, it is preferable that the PNP transistor and the NPN transistor in the buffer circuit section of the power converter according to the first aspect be connected in a totem-pole configuration and the node connecting the NPN transistor and the PNP transistor be connected with the gate terminal of the power semiconductor device.
According to a third aspect of the present invention, it is preferable that the first MOSFET of the power converter according to the second aspect include an N channel MOSFET, the N channel MOSFET be electrically connected in series with the NPN transistor, and the first delay circuit section include an inverting circuit section for generating an inverted signal obtained by inverting the driving signal and output the inverted signal as the first delay signal.
According to a fourth aspect of the present invention, the power converter according to the first aspect preferably includes a second delay circuit section that receives the driving signal and that generates a second delay signal on the basis of the received driving signal and a second MOSFET that has a drain electrode connected with the output of the buffer circuit section and that is driven on the basis of the second delay signal. It is preferable that a current flow through the buffer circuit section and the second MOSFET on the basis of the received driving signal, the second delay circuit section output a second delay signal after the buffer circuit section exits the transient state and turns on, and the gate voltage be applied to the power semiconductor device from the buffer circuit section to turn the power semiconductor device off by the switching operation of the second MOSFET based on the second delay signal.
According to a fifth aspect of the present invention, it is preferable that the NPN transistor and the PNP transistor in the buffer circuit section of the power converter according to the fourth aspect be connected in a totem-pole configuration and the node connecting the NPN transistor and the PNP transistor be connected with the gate terminal of the power semiconductor device.
According to a sixth aspect of the present invention, it is preferable that the second MOSFET of the power converter according to the fifth aspect include a P channel MOSFET, the P channel MOSFET be electrically connected in series with the PNP transistor, and the second delay circuit section include an inverting circuit section for generating an inverted signal obtained by inverting the driving signal and output the inverted signal as the second delay signal.

### Advantageous Effects of Invention

The present invention enables the losses generated during the switching operations to be further reduced. Brief Description of Drawings

Fig. 1 is an input/output interface circuit diagram of an inverter commonly used in hybrid electric vehicles (HEVs) or electric vehicles (EVs).
Fig. 2 is a circuit diagram showing the specific configuration of a power semiconductor device driving circuit used in common inverter circuits.
Fig. 3 is a circuit diagram showing the specific configuration of a power semiconductor device driving circuit according to a first embodiment of the present invention.
Fig. 4 is a circuit diagram showing the specific configuration of a power semiconductor device driving circuit according to a second embodiment of the present invention.
Fig. 5 is a timing chart diagram showing waveforms in the output section of a conventional circuit.
Fig. 6 is a timing chart diagram showing waveforms in the output section according to the first embodiment.
Fig. 7 is a timing chart diagram showing waveforms in the output section according to the second embodiment.
Fig. 8(a) is a perspective view of a power module 370 according to an embodiment of the present invention. Fig. 8(b) is a sectional view of the power module 370 according to the embodiment.
Fig. 9(a) is an exploded view for better understanding the structure shown in Fig. 8. Fig. 9(b) is a circuit diagram of the power module 370.
Fig. 10(a) is a circuit diagram for describing an inductance reduction effect, and Fig. 10(b) is a perspective view showing current flows for describing the inductance reduction effect.

### Description of Embodiments

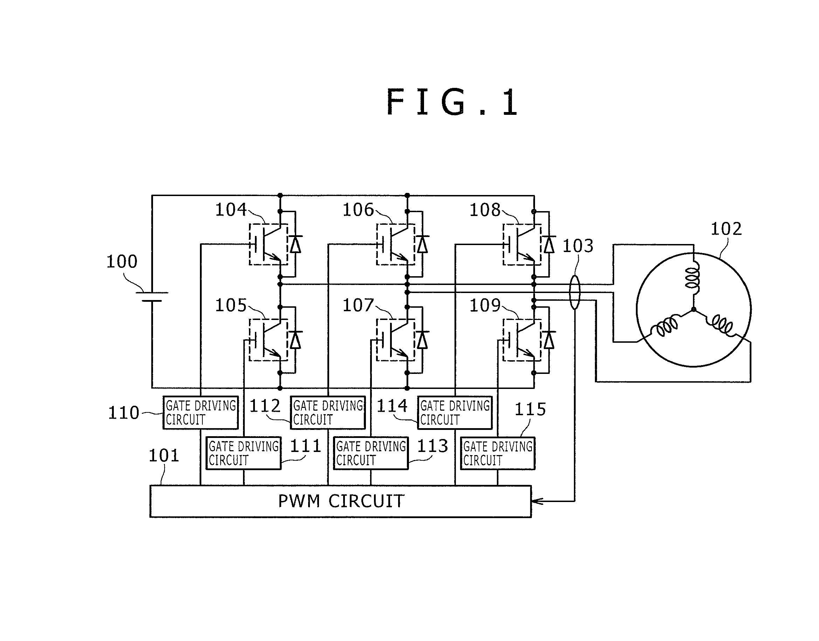

Fig. 1 is a system diagram of an inverter commonly used in hybrid electric vehicles (HEVs) or electric vehicles (EVs). This inverter system includes power semiconductor devices 104 to 109 for converting a DC voltage supplied from a battery 100 into an AC voltage, a motor 102, a current sensor 103 for sensing the currents from the power semiconductor devices 104 to 109, a PWM circuit 101 incorporating a CPU, a counter circuit, an input/output circuit, etc., and gate driving circuits 110 to 115 for driving the power semiconductor devices 104 to 109. The gate driving circuits include a circuit for reducing the losses generated in the inverter. Here, the gate driving circuits 110 to 115 are configured so that they correspond to respective arms.

According to the circuit configuration shown in Fig. 1, the current sensor 103 senses the currents output from the power semiconductor devices 104 to 109 and causes the PWM circuit 101 to perform the PWM (Pulse Width Modulation) operation in which the differences between set values and the detected current values are reduced to zero, so that PWM signals (pulse signals) including alternating ON and OFF signals for the power semiconductor devices 104 to 109 are output from the PWM circuit 101 to the gate driving circuits 110 to 115. As the gate driving circuits 110 to 115 are negative logic circuits, they output an ON signal when the "L" logic level is input while they output an OFF signal when the "H" logic level is input.
As described above, the PWM circuit 101 outputs the PWM signals to the gate driving circuits to control the gate driving circuits so that the outputs from the gate driving circuits control the output currents from the power semiconductor devices to drive the motor 102 in a controlled manner. Therefore, the PWM circuit 101 has a function for driving the motor in a controlled manner.

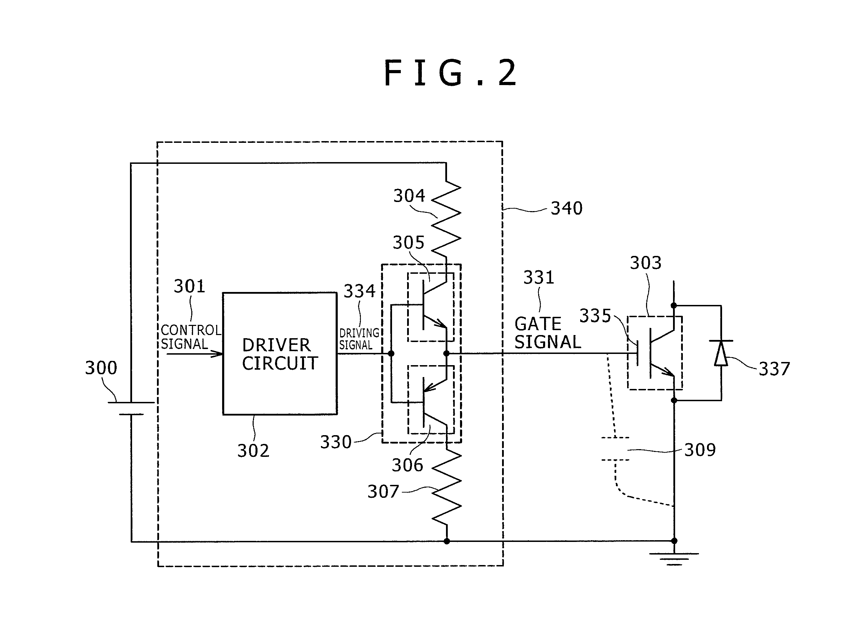

Fig. 2 shows an arm (upper or lower arm) of the inverter in Fig. 1. More specifically, it is the circuit configuration diagram of one (upper or lower arm) of the arms constituted by the power semiconductor devices 104 to 109 and the gate driving circuits 110 to 115 for respectively driving them. As the gate driving circuits 110 to 115 basically has the same configuration and function, the operation of the gate driving circuits will be described using one set of a power semiconductor device and a gate driving circuit shown in Fig. 2.

A power supply 300 supplies power to a gate driving circuit 340 shown in Fig. 2 to drive the gate driving circuit 340, which is one of the gate driving circuits 110 to 115 shown in Fig. 1. A driver circuit 302 receives a control signal 301 for controlling the switching operation of a power semiconductor device.

A buffer circuit 330 includes an NPN transistor 305 and a PNP transistor 306; the NPN transistor 305 and the PNP transistor 306 are connected in a totem-pole configuration so that they are electrically connected in series. While a gate resistor 304 is connected with the drain electrode of the NPN transistor 305, a gate resistor 307 is connected with the source electrode of the PNP transistor 306.

The control signal 301 output from the PWM circuit 101 is output as a driving signal 334 via the driver circuit 302. Here, the driving signal 334 functions as a buffer driving signal for driving the buffer circuit 330.

The driving signal 334 is output as a gate voltage signal 331 via the buffer circuit 330.

In the power semiconductor device 303, there exists a gate-emitter parasitic capacitance 309 between the gate and emitter electrodes thereof. The turning-on speed of the power semiconductor device 303 is determined by the time constant of the section constituted by the gate resistor 304 connected with the turn-on driving transistor (NPN transistor 305), the NPN transistor 305, and the gate-emitter parasitic capacitance 309.

In conventional circuits, in order to increase the turning-on speed of the power semiconductor device 303, the resistance value of the gate resistor 304 is reduced. However, as the turning-on speed of the power semiconductor device 303 is limited by the transient response time required for the NPN transistor 305 of the buffer circuit 330 to exit the transient state and turn on completely, it cannot be increased further no matter how the resistance value of the gate resistor 304 is reduced. Here, the transient response time means an amount of time required for a transistor to turn on completely, i.e., to switch to the fully active state, after it starts the transition to the turned-on state.

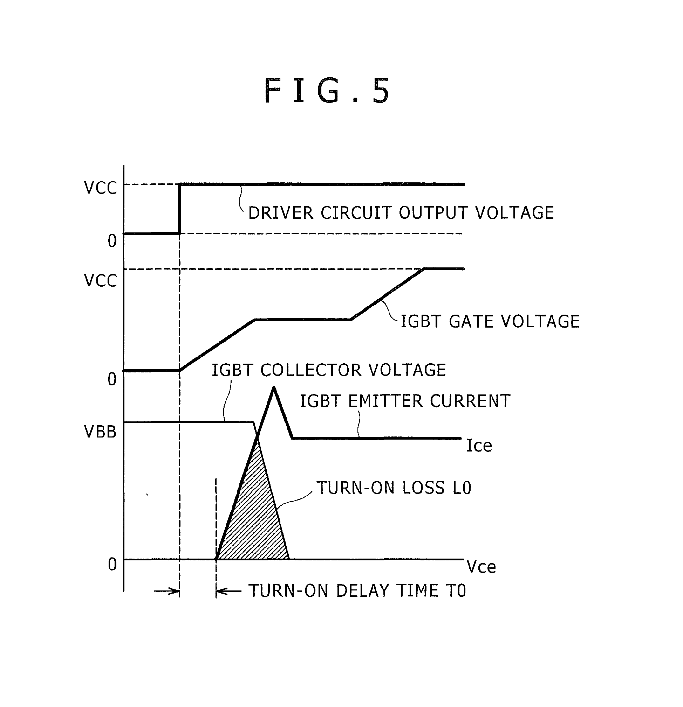

Fig. 5 shows a timing chart of a power semiconductor device used in common inverters. In Fig. 5, driver circuit output voltage represents the driving signal 334 shown in Fig. 2, IGBT gate voltage represents the gate voltage signal 335 shown in Fig. 2, IGBT emitter current represents the current that flows between the emitter and the collector of the power semiconductor device 303, and IGBT collector voltage represents the collector-emitter voltage of the power semiconductor device 303. In this figure, VBB denotes the DC voltage supplied by the battery power supply 100 while VCC denotes the DC voltage supplied by the power supply 300.

Turn-on time T0 represents an amount of time required for the emitter current of the power semiconductor device 303 to start to flow after the driving signal 334 is input into the buffer circuit 330. An area integrated with respect to the IGBT emitter current and the IGBT collector voltage (the hatched area in Fig. 5) corresponds to switch-on loss L0.

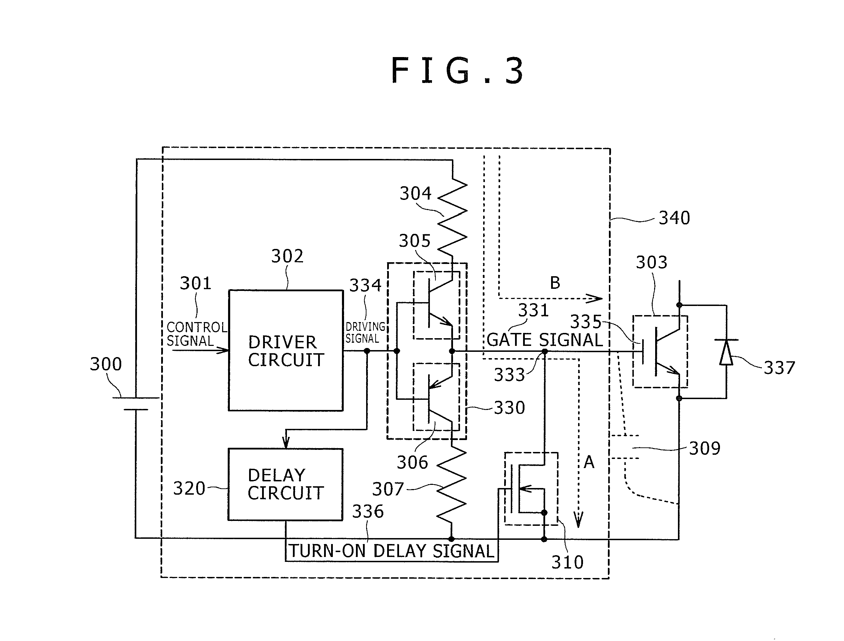

Fig. 3 shows a gate driving circuit according to a first embodiment of the present invention.
An N channel MOSFET 310 is connected between the gate terminal 333 of the power semiconductor device 303 and GND. Furthermore, the N channel MOSFET 310 is not only electrically connected in series with the NPN transistor 305 but also electrically connected in parallel with the PNP transistor 306.

In addition, a delay circuit 320 receives the driving signal 334 from wiring connecting the driver circuit 302 and the buffer circuit 330 and outputs a turn-on delay signal 336 after a predetermined amount of time has elapsed since the receipt of the driving signal 334. The delay circuit 320 may also receive the driving signal 334 output from the driver circuit 302 using wiring other than the above-described wiring. In the present embodiment, the delay circuit 320 is provided with an inverting circuit section for generating an inverted signal obtained by inverting the driving signal 334. The inverted signal is output as the turn-on delay signal 336.

In the present embodiment, the driving signal 334 output from the driver circuit 302 is input into the buffer circuit 330 and the delay circuit 320. The turn-on delay signal 336 is controlled so that the N channel MOSFET 310 remains in the turned-on state until the NPN transistor 305 in the buffer circuit 330 exits the transient state completely (current path A). More specifically, the delay circuit 320 functions as a circuit for controlling the N channel MOSFET 310 by outputting the turn-on delay signal 336.

By turning the N channel MOSFET 310 off with the NPN transistor 305 turned on completely, a gate voltage is applied to the power semiconductor device 303 with the NPN transistor 305 turned on completely so as to drive the power semiconductor device 303 (current path B).

The resistance value of the gate resistor 304 connected with the turn-on transistor (NPN transistor 305) is selected so that the maximum current rating of the NPN transistor 305 is not exceeded. A transistor whose driving ability (maximum current rating) is low or whose response is extremely poor (slow) may find difficulty in achieving the advantage of the present embodiment.

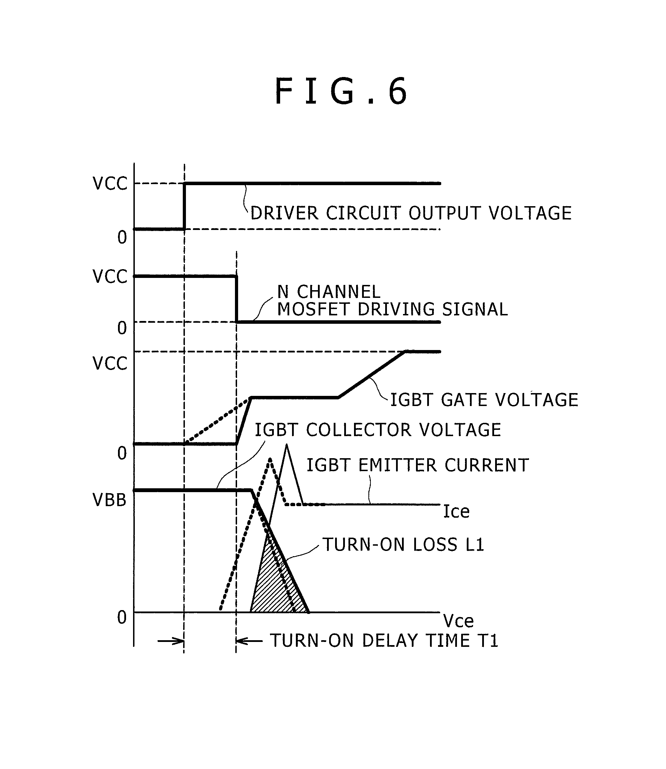

Fig. 6 shows a timing chart of the gate driving circuit shown in Fig. 3. In Fig. 6, driver circuit output voltage represents the driving signal 334 in Fig. 3, N channel MOSFET driving signal represents the turn-on delay signal 336 in Fig. 3, IGBT emitter current represents the main current that flows through the power semiconductor device 303 in Fig. 3, and IGBT collector voltage represents the collector-emitter voltage of the power semiconductor device 303 in Fig. 3.

Here, turn-on delay time T1 in Fig. 6 denotes the delay time in the delay circuit 320. Furthermore, this turn-on delay time T1 is set so as to be greater than the turn-on delay time T0 in Fig. 5 which is determined by the characteristics and the parasitic capacitance 309 of each power semiconductor device 303.
Although not shown in the figure, the output of the N channel MOSFET driving signal at the VCC voltage is performed with a predetermined time delay after the driver circuit output voltage reaches 0V.

Increasing the speed of the gate voltage applied to the IGBT enables high speed response to be achieved for both the IGBT emitter current and the IGBT collector voltage, thus enabling turn-on loss L1 to be reduced. The turn-on loss L1 corresponds to the area integrated with respect to the IGBT emitter current and the IGBT collector voltage (the hatched area in Fig. 6). The dotted lines of the IGBT gate voltage, the IGBT emitter current, and the IGBT collector voltage represent the waveforms obtained when the conventional driving circuit (Fig. 2) is operated.

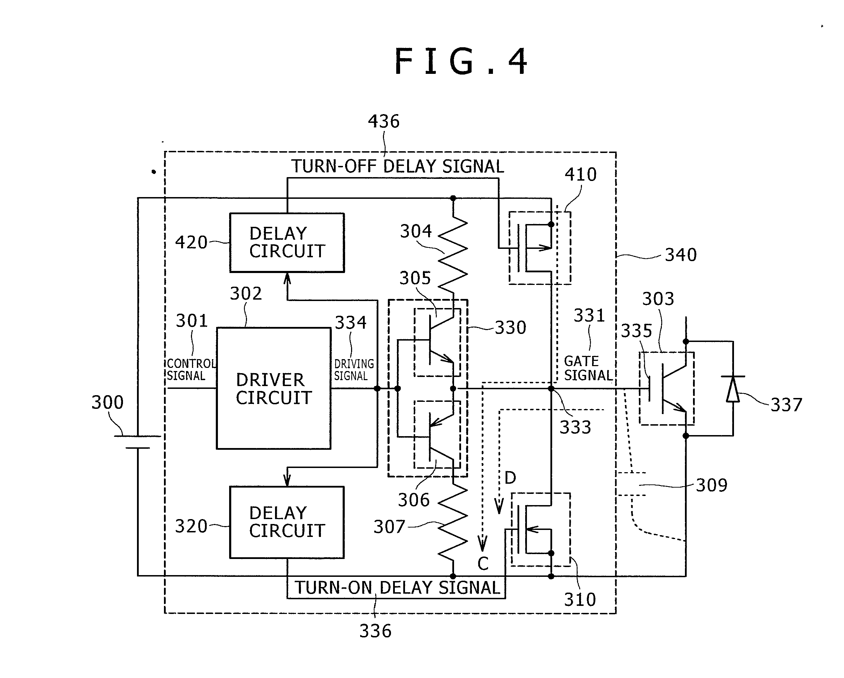

Fig. 4 is a diagram showing a gate driving circuit according to a second embodiment of the present invention. The gate driving circuit according to the present embodiment includes, in addition to the gate driving circuit shown in Fig. 3, a P channel MOSFET 410 connected between the gate terminal 333 of the power semiconductor device 303 and the power supply 300. Furthermore, a delay circuit 420 receives the driving signal 334 from wiring connecting the driver circuit 302 and the buffer circuit 330 and generates a turn-off delay signal 436 after a predetermined amount of time has elapsed since the receipt of the driving signal 334.

The delay circuit 420 may also receive the driving signal 334 output from the driver circuit 302 using wiring other than the above-described wiring. In the present embodiment, the delay circuit 420 is provided with an inverting circuit section for generating an inverted signal obtained by inverting the driving signal 334. The inverted signal is output as the turn-off delay signal 436.

In addition to the first embodiment of the present invention, the driving signal 334 output from the driver circuit 302 is input into the buffer circuit 330 and the delay circuit 420 in the present embodiment. The turn-off delay signal 436 is controlled so that the P channel MOSFET 410 remains in the turned-on state until the PNP transistor 306 in the buffer circuit 330 exits the transient state completely (current path C). More specifically, the delay circuit 420 functions as a circuit for controlling the P channel MOSFET 410 by outputting the turn-off delay signal 436.

By turning the P channel MOSFET 410 off with the PNP transistor 405 turned on completely, a gate voltage is applied to the power semiconductor device 303 with the PNP transistor 405 turned on completely so as to drive the power semiconductor device 303 (current path D).

The resistance value of the gate resistor 307 connected with the turn-off transistor (PNP transistor 306) is selected so that the maximum current rating of the PNP transistor 306 is not exceeded. A transistor whose driving ability (maximum current rating) is low or whose response is extremely poor (slow) may find difficulty in achieving the advantage of the present embodiment.

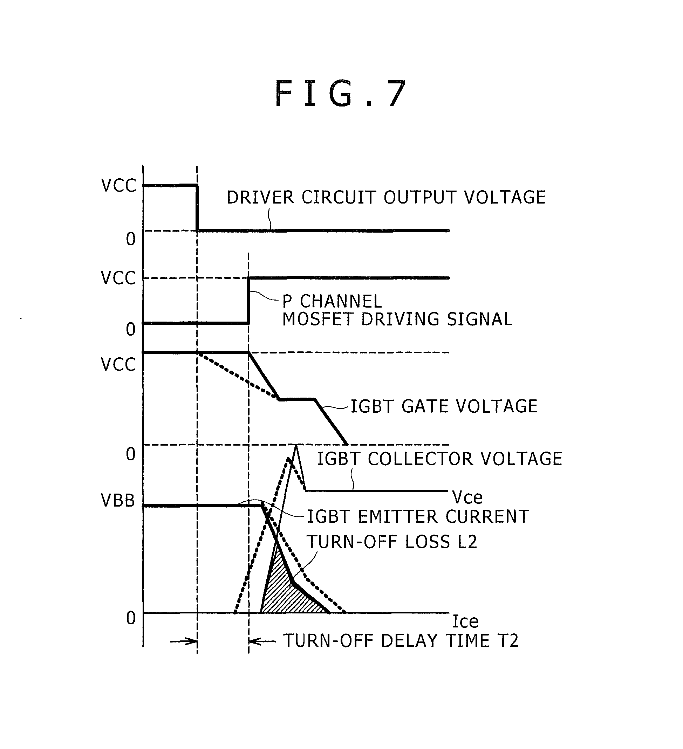

Fig. 7 shows a timing chart of circuit sections according to the present invention. In Fig. 7, driver circuit output voltage represents the driving signal 334 in Fig. 4, P channel MOSFET driving signal represents the turn-off delay signal 436 in Fig. 4, IGBT emitter current represents the main current that flows through the power semiconductor device 303, and IGBT collector voltage represents the collector-emitter voltage of the power semiconductor device 303.

Here, turn-off delay time T2 in Fig. 7 represents the delay time in the delay circuit 420 that drives the P channel MOSFET 410.
Although not shown in the figure, the output of the P channel MOSFET driving signal at the VCC voltage is performed with a predetermined time delay after the driver circuit output voltage reaches VCC. Furthermore, when both the N channel MOSFET and the P channel MOSFET are used as shown in Fig. 4, they are controlled so as not to turn on simultaneously. For example, the output of the N channel MOSFET driving signal at the VCC voltage is performed after the turn-off delay time T2 in Fig. 7 has elapsed.

Increasing the speed of the IGBT gate voltage enables high speed response to be achieved for both the IGBT emitter current and the IGBT collector voltage, thus enabling turn-off loss L2 to be reduced. The turn-off loss L2 corresponds to the area integrated with respect to the IGBT emitter current and the IGBT collector voltage (the hatched area in Fig. 7). The dotted lines of the IGBT gate voltage, the IGBT emitter current, the IGBT collector voltage represent the waveforms obtained when the conventional driving circuit (Fig. 2) is operated.

However, for IGBTs, which are commonly used power semiconductor devices, a substantial portion of the turn-off loss is generated by the tail current of the IGBT itself, thus making it difficult to reduce the turn-off loss only by increasing the speed of the driver circuit.

Using a circuit according to the second embodiment of the present invention enables IGBTs to be used at high carrier frequencies, which has been difficult due to their high switching losses (heat generation), thus enabling inverters to obtain boarder control ranges.

On the other hand, as the reduction of the turning-on time of the power semiconductor device 303 may increase the overshoot voltage, it is preferable that a power module having a reduced wiring inductance be used in order to suppress the increase in the overshoot voltage. In this regard, a power module suitable for the gate driving circuits according to the first and second embodiments of the present invention is described below.

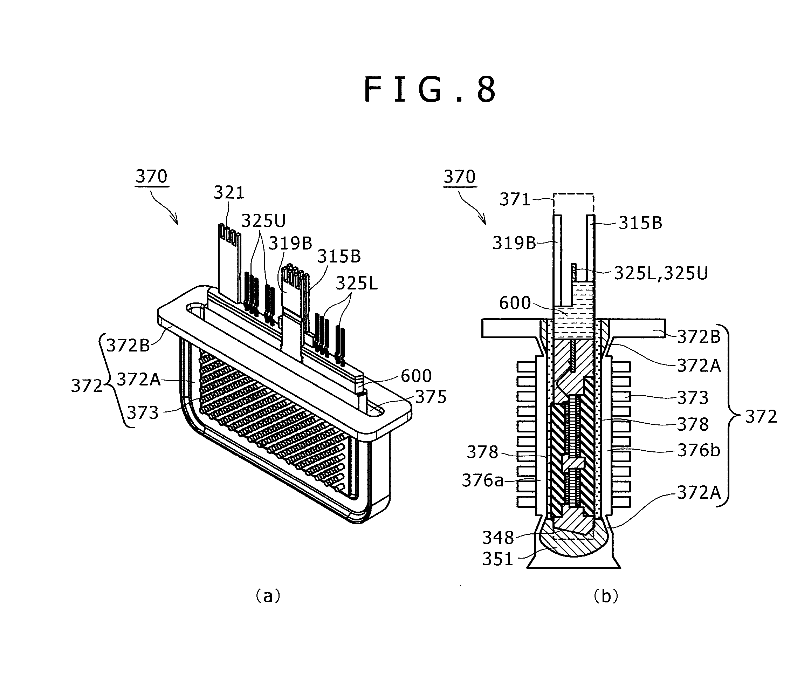

The detailed configuration of a power module 370 will be described with reference to Figs. 8 to 10. Fig. 8(a) is a perspective view showing the power module 370 having a power converter according to either the first embodiment or the second embodiment of the present invention. Fig. 8(b) is a sectional view of this power module 370.

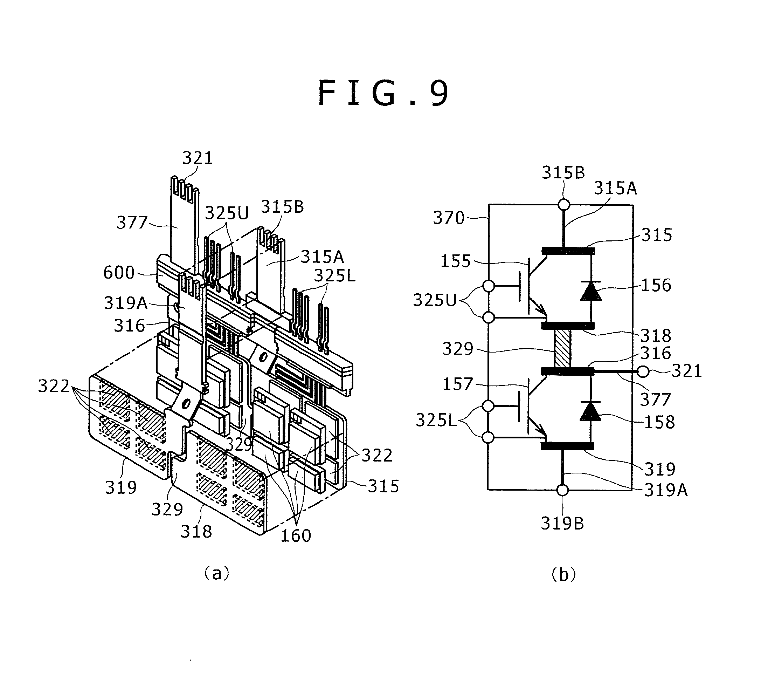

Power semiconductor devices (an IGBT 328, an IGBT 374, a diode 156, and a diode 166) are fixedly sandwiched between a conductor plate 315 and a conductor plate 318 or between a conductor plate 316 and a conductor plate 319 as shown in Fig. 9. An auxiliary mold member 600 obtained by integrally molding signal wiring, i.e., signal terminals 325U and signal terminals 325L, are assembled with these conductor plates.

The conductor plates 315 to 319 are sealed by a first sealing resin 348 with their heat dissipation surfaces exposed, and insulator sheets 378 are thermo-compression bonded to the heat dissipation surfaces. A preliminarily sealed module unit 371 obtained in this manner by sealing the components using the first sealing resin 348 is inserted into a module case 372 and is thermo-compression bonded to the inner surfaces of the module case 372 with the insulator sheets 378 sandwiched therebetween. The module case 372 is a CAN type cooler. Here, the CAN type cooler is a can-shaped cooler having an insertion opening 375 on one side and a bottom wall on the other side.

The module case 372 is formed of an aluminum alloy material, such as Al, AlSi, AlSiC, Al-C, and is integrally molded with no seams. The module case 372 has no openings other than the insertion opening 375, and the insertion opening 375 is circumferentially surrounded by a flange 372B. Furthermore, as shown in Fig. 8(b), first and second heat dissipation surfaces 376a and 376b having larger areas than other surfaces are disposed on opposite sides so as to face each other, three surfaces connecting the mutually facing first and second heat dissipation surfaces 376a and 376b constitute a sealed wall having a narrower width than the first and second heat dissipation surfaces 376a and 376b, and the insertion opening 375 is formed in the remaining one side.

Using a metal case having such a shape enables the module case to be tightly sealed from a coolant by the flange 372B even if the module case 372 is inserted into a flow path through which a coolant such as water or oil flows. As a result, with a simple configuration, the coolant can be prevented from flowing into the inside of the module case 372. In addition, fins 373 are formed so as to be distributed uniformly on the mutually facing first and second heat dissipation surfaces 376a and 376b. Furthermore, curved sections 372A having an extremely thin thickness are formed on the peripheries of the first and second heat dissipation surface 376a 376b. The curved sections 372A have an extremely thin thickness so that they can be easily deformed by pressing the fins 372, thus enabling the productively to be improved after the preliminarily sealed module unit 371 is inserted.

The gap remaining inside the module case 372 is filled with a second sealing resin 351. Furthermore, as shown in Fig. 9, DC positive electrode wiring 315A and DC negative electrode wiring 319A are provided for electrically connecting with a capacitor, and DC positive electrode terminal 315B and a DC negative electrode terminal 319B are formed on their tips. AC wiring 377 is provided for supplying AC power to the motor, and an AC terminal 321 is formed on its tip. In the present embodiment, the DC positive electrode wiring 315A is integrally molded with the conductor plate 315, the DC negative electrode wiring 319A is integrally molded with the conductor plate 319, and the AC wiring 377 is integrally molded with the conductor plate 316.

Thermo-compression bonding the conductor plates 315 to 319 to the inner surfaces of the module case 372 with the insulator sheets 378 sandwiched therebetween enables the gap between the conductor plates and the inner surfaces of the module case 372 to be reduced, thus enabling the heat generated by the power semiconductor devices to be conducted to the fins 373. Furthermore, if the insulator sheets 378 have an appropriate thickness and flexibility, the insulator sheets 378 can absorb generated thermal stress, thus making the power module suitable for use in power converters mounted in vehicles, which may experience drastic changes in temperature.

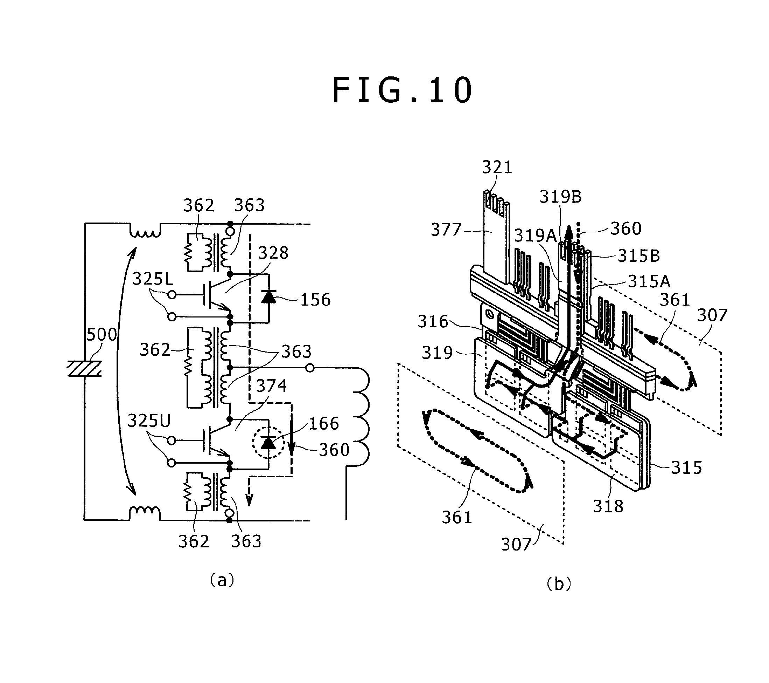

Fig. 9(a) is an exploded view for better understanding the structure shown in Fig. 8. Fig. 9(b) is a circuit diagram of the power module 370. In addition, Fig. 10(a) is a circuit diagram for describing an inductance reduction effect while Fig. 10(b) is a perspective view showing current flows for describing the inductance reduction effect.

First, the disposition of the power semiconductor devices (the IGBT 328, the IGBT 374, the diode 156, and the diode 166) and the conductor plates will be described in connection with the electric circuit shown in Fig. 9(b). As shown in Fig. 8(a), the conductor plate 315 connected with the DC positive electrode and the conductor plate 316 connected with the AC output are disposed so as to be substantially coplanar. The collector electrode of the IGBT 328 in the upper arm and the cathode electrode of the diode 156 in the upper arm are fixedly attached to the conductor plate 315. The collector electrode of the IGBT 374 in the lower arm and the cathode electrode of the diode 166 in the lower arm are fixedly attached to the conductor plate 316.

In a similar manner, the AC conductor plate 318 and the conductor plate 319 are disposed so as to be substantially coplanar. The emitter electrode of the IGBT 328 in the upper arm and the anode electrode of the diode 156 in the upper arm are fixedly attached to the AC conductor plate 318. The emitter electrode of the IGBT 374 in the lower arm and the anode electrode of the diode 166 in the lower arm are fixedly attached to the conductor plate 319. The power semiconductor devices are fixedly attached to device attachment sections 322 provided on the conductor plates via metal bonding members 160, respectively. The metal bonding members 160 may be formed of a soldering material, a silver sheet, or a low-temperature sintered bonding material including fine metal particles, for example.

Each power semiconductor device has a plate-like flat structure, and the electrodes of the power semiconductor devices are formed on their front and rear surfaces. The electrodes of the power semiconductor devices are sandwiched between the conductor plate 315 and the conductor plate 318 or between the conductor plate 316 and the conductor plate 319. More specifically, the conductor plate 315 and the conductor plate 318 are disposed facing each other so as to form a substantially parallel stack with the IGBT 328 and the diode 156 sandwiched therebetween. In a similar manner, the conductor plate 316 and the conductor plate 319 are also disposed facing each other so as to form a substantially parallel stack with the IGBT 374 and the diode 166 sandwiched therebetween. Furthermore, the conductor plate 316 and the conductor plate 318 are connected via an intermediate electrode 329. With this'connection, the upper arm circuit and the lower arm circuit are electrically connected to form a serially connected upper/lower arm circuit.

The DC positive electrode wiring 315A and the DC negative electrode wiring 319A have a shape that extends facing each other in a substantially parallel manner, with the auxiliary mold member 600 obtained by molding a resin material sandwiched therebetween. The signal terminals 325U and the signal terminals 325L are integrally molded with the auxiliary mold member 600 and extend in a direction identical to that of the DC positive electrode wiring 315A and the DC negative electrode wiring 319A. An insulating thermal setting or thermoplastic resin is suitable to be used as the resin material for the auxiliary mold member 600. This enables insulation between the DC positive electrode wiring 315A and DC negative electrode wiring 319A and between the signal terminals 325U and signal terminals 325L to be secured, thus enabling high density wiring to be achieved. Furthermore, by disposing the DC positive electrode wiring 315A and the DC negative electrode wiring 319A so as to face each other in a substantially parallel manner, currents that flow instantaneously during the switching operations of the power semiconductor devices flow in a mutually facing manner in opposite directions. This causes the magnetic fields generated by the currents to cancel one another, thus enabling inductance to be reduced.

Further reduction in inductance can be achieved by a loop current shown in Fig. 10.
In Fig. 10(a), assume that the diode 166 in the lower arm is in the conductive state with a forward bias applied. In this state, when the IGBT 328 in the upper arm is turned on, the diode 166 in the lower arm is reverse biased, causing a recovery current due to carrier transport to flow through both the upper and the lower arms. At that time, the recovery current 360 flows through the conductor plates 315, 316, 318 and 319 as shown in Fig. 10(b). As shown by the dotted line, the recovery current 360 passes through the DC positive electrode terminal 315B disposed to face the DC negative electrode terminal 319B, flows through a loop shaped path formed by the conductor plates 315, 316, 318, and 319, and then flows through the DC negative electrode terminal 319B disposed to face the DC positive electrode terminal 315B as shown by the solid line. The current flowing through the loop shaped path causes eddy currents 361 to flow in the first heat dissipation surface 376a and the second heat dissipation surface 376b. The magnetic field cancelling effect generated by circuits 362 that are equivalent to the current paths of the eddy currents 361 reduces the wiring inductance 363 in the loop shaped path.

As the degree of similarity of the shape of the current path for the recovery current 360 to that of a loop becomes higher, the inductance reduction effect is increased. In the present embodiment, the loop shaped current path first passes through a path in the conductor plate 315 near the DC positive electrode terminal 315B'as shown by the dotted line, and passes through the IGBT 328 and the diode 156. Next, the loop shaped current path passes through a path in the conductor plate 318 far from the DC positive electrode terminal 315B as shown by the solid line, then passes through a path in the conductor plate 316 far from the DC positive electrode terminal 315B as shown by the dotted line, and passes through the IGBT 374 and the diode 166. Next, the loop shaped current path passes through a path in the conductor plate 319 near the DC negative electrode wiring 319A as shown by the solid line. In this manner, as the loop shaped current path passes through the paths that are near or far from the DC positive electrode terminal 315B and the DC negative electrode terminal 319B, a current path having a shape that is similar to a loop is formed.

The above-described power module 370 can be used to suppress the overshoot voltage. As a result, an appropriate balance between the switching loss suppression using the gate driving circuits described with reference to Figs. 3 and 4 and the overshoot voltage suppression using the power module 370 can be achieved.

As apparent from the foregoing description, it is also possible to reduce only the turn-off loss by eliminating the first MOSFET (N channel MOSFET 310) and the delay circuit 320 from the configuration of the gate driving circuit shown in Fig. 4 with the second MOSFET, i.e., the P channel MOSFET 410, and the delay circuit 420 kept as-is.

Although various embodiments and variants have been described above, the present invention is not limited thereto. Other embodiments that are considered to fall within the scope of the technical concept of the present invention are also encompassed within the scope of the present invention.

The content disclosed in the following application, upon which priority is claimed, is hereby incorporated herein by reference:
Japanese Patent Application 2010-084774 (filed on April 1, 2010)

## Claims

1. A power converter, comprising:
a power semiconductor device;
a driver circuit section that outputs a driving signal for driving the power semiconductor device;
a buffer circuit section that includes a PNP transistor and an NPN transistor and that outputs a gate voltage for driving the power semiconductor device;
a first delay circuit section that receives the driving signal and that generates a first delay signal based on the received driving signal; and
a first MOSFET that has a drain electrode connected with an output of the buffer circuit section and that is driven based on the first delay signal, wherein
a current flows through the buffer circuit section and the first MOSFET based on the received driving signal,
the first delay circuit section outputs the first delay signal after the buffer circuit section exits a transient state and turns on, and
the gate voltage is applied to the power semiconductor device from the buffer circuit section to turn the power semiconductor device on by a switching operation of the first MOSFET based on the first delay signal.

2. The power converter of Claim 1, wherein
the PNP transistor and the NPN transistor in the buffer circuit section are connected in a totem-pole configuration, and
a node connecting the NPN transistor and the PNP transistor is connected with a gate terminal of the power semiconductor device.

3. The power converter of claim 2, wherein
the first MOSFET includes an N channel MOSFET, and the N channel MOSFET is electrically connected in series with the NPN transistor, and
the first delay circuit section includes an inverting circuit section for generating an inverted signal obtained by inverting the driving signal and outputs the inverted signal as the first delay signal.

4. The power converter of claim 1, comprising:
a second delay circuit section that receives the driving signal and that generates a second delay signal based on the received driving signal; and
a second MOSFET that has a drain electrode connected with an output of the buffer circuit section and that is driven based on the second delay signal, wherein
a current flows through the buffer circuit section and the second MOSFET based on the received driving signal,
the second delay circuit section outputs the second delay signal after the buffer circuit section exits the transient state and turns on, and
the gate voltage is applied to the power semiconductor device from the buffer circuit section to turn the power semiconductor device off by a switching operation of the second MOSFET based on the second delay signal.

5. The power converter of claim 4, wherein
the PNP transistor and the NPN transistor in the buffer circuit section are connected in a totem-pole configuration, and
a node connecting the NPN transistor and the PNP transistor is connected with a gate terminal of the power semiconductor device.

6. The power converter of claim 5, wherein
the second MOSFET includes a P channel MOSFET, and the P channel MOSFET is electrically connected in series with the PNP transistor, and
the second delay circuit section includes an inverting circuit section for generating an inverted signal obtained by inverting the driving signal and outputs the inverted signal as the second delay signal.
